# EUROPÄISCHE PATENTSCHRIFT

(11) **EP 3 550 582 B1**
(45) Veröffentlichungstag und Bekanntmachung des Hinweises auf die Patenterteilung: **14.10.2020**
(21) Anmeldenummer: 19165372.4
(22) Anmeldetag: 27.03.2019
(51) Int. Cl.: H01H 9/54

(54) **NIEDERSPANNUNGS-SCHUTZSCHALTGERÄT**
LOW VOLTAGE CIRCUIT BREAKER
DISJONCTEUR DE PROTECTION BASSE TENSION

(30) Priorität: 06.04.2018 DE 102018108138
(43) Veröffentlichungstag der Anmeldung: 09.10.2019
(73) Patentinhaber: Eaton Intelligent Power Limited, Dublin 4 (IE)
(72) Erfinder: ASKAN, Kenan, 1090 Wien (AT)
(74) Vertreter: Eaton IP Group EMEA

(56) Entgegenhaltungen:
- WO-A1-2015/028634
- GB-A- 2 520 959
- US-A1- 2007 108 959

## Beschreibung

Die Erfindung betrifft ein Niederspannungs-Schutzschaltgerät gemäß dem Oberbegriff des Patentanspruches 1.

Ein hybrides Niederspannungs-Schutzschaltgerät ist aus der WO 2015/028634 A1 der Anmelderin bekannt. Dabei ist eine IGBT/Dioden-Schaltung parallel zu einem Bypassschalter angeordnet. Zum Abschalten eines Stromes wird der Bypassschalter geöffnet, wodurch der Strom über das Niederspannungs-Schutzschaltgerät auf die IGBT-Schaltung kommutiert. Nachfolgend wird der Strom mittels der IGBT-Schaltung abgeschaltet.

Die IGBT-Schaltung ist dabei ständig eingeschaltet. Dabei ist es beabsichtigt, dass es im Falle eines Kurzschlusses zu einer Sättigung des IGBT kommt, Seite 11, Zeile 10 bis 15. Dies wird durch den IGBT-Treiber erkannt, woraufhin der IGBT abgeschaltet wird.

Es hat sich gezeigt, dass bei einem derartigen Niederspannungs-Schutzschaltgerät die IGBT-Schaltung stark belastet wird, und dadurch deren Lebensdauer leidet. Da Schutzschaltgeräte über Jahrzehnte zuverlässig funktionieren müssen, ist dies äußerst problematisch. Die Entsättigung der Collector-Emitter-Spannung bei einem Abschalten eines Kurzschlusses führt dazu, dass der maximale Strom über den IGBT begrenzt wird, die Verlustleistung rapide ansteigt, und es zu einer thermischen Überlastung des IGBT kommen kann, welcher bis zu einem Totalverlust des IGBT führen kann. Um dennoch sicher hohe Kurzschlussströme abschalten zu können, ist es bei einem derartigen Konzept vorgesehen, mehrere IGBT parallel zu schalten. Dies löst zwar die Probleme hinsichtlich der Stromtragfähigkeit der Gesamtanordnung und auch der thermischen Überlastung, führt jedoch zu einem deutlich aufwendigeren und bauteilintensiveren Aufbau. Weiters wird dadurch die Schleifeninduktanz erhöht, was wiederum die Kommutationszeit eines Stromes im Kurzschlussfall vergrößert, und derart also zahlreiche neue Probleme schafft.

Aufgabe der Erfindung ist es daher ein Niederspannungs-Schutzschaltgerät der eingangs genannten Art anzugeben, mit welchem die genannten Nachteile vermieden werden können, und welches eine lange Lebensdauer und eine geringe Baugröße aufweist.

Erfindungsgemäß wird dies durch die Merkmale des Patentanspruches 1 erreicht.

Dadurch können auch hohe Kurzschlussströme mit nur einem einzigen Leistungshalbleiterbauteil, beispielsweise einem IGBT oder MOSFET, sicher abgeschaltet werden, ohne dass es zu thermischen Problemen oder einer Beeinträchtigung der Lebensdauer des Niederspannungs-Schutzschaltgeräts kommt. Natürlich können dadurch auch Überströme die geringer sind als ein Kurzschlussstrom sicher abgeschaltet werden.

Dadurch kann der Zustand der Entsättigung (desaturation) der Spannung beim Abschalten eines Überstromes oder Kurzschlussstromes sicher verhindert werden. Da keine Entsättigung (desaturation) an dem Leistungshalbleiter auftritt, kann dieser auch einen entsprechend hohen Strom bei geringer Verlustleistung übertragen. Dabei wird durch die Überhöhung der Gate-Spannung gegenüber der Gate-Spitzenspannung des IGBT oder MOSFET keineswegs die Lebensdauer des Leistungshalbleiters verringert. Die entsprechenden Werte der Gate-Spitzenspannung sind in den Datenblättern jeweils für einen Dauerbetrieb des jeweiligen Bauteils definiert. Da die gegenständlich beschriebene Erhöhung der Gate-Spannung jedoch nur sehr kurzzeitig und auch nur beim Abschalten eines Überstromes oder Kurzschlusses, welche verhältnismäßig selten auftreten, erfolgt, wird der Leistungshalbleiter während einer typischen Lebensdauer des Niederspannungs-Schutzschaltgeräts von 20 bis 25 Jahren nur für wenige Millisekunden mit der deutlich überhöhten Gate-Spannung betrieben. Dies verringert die Lebensdauer des Leistungshalbleiters nicht. Dadurch kann die Lebensdauer eines Niederspannungs-Schutzschaltgeräts verlängert werden.

Durch die Verwendung nur eines einzigen Leistungshalbleiterbauteils können weiters die Leitungswege kurz und damit die Schleifeninduktivität gering gehalten werden, wodurch ein Kurzschlussstrom schneller auf den Leistungshalbleiter kommutiert. Dadurch kann die Zeitdauer, während derer der Leistungshalbleiter belastet wird weiters reduziert und die Lebensdauer weiter erhöht werden.

Die Unteransprüche betreffen weitere vorteilhafte Ausgestaltungen der Erfindung.

Die Erfindung betrifft weiters ein Verfahren zum Betrieb eines Niederspannungs-Schutzschaltgeräts gemäß dem Patentanspruch 7.

Aufgabe der Erfindung ist es daher ein Verfahren zum Betrieb eines Niederspannungs-Schutzschaltgeräts anzugeben, mit welchem die eingangs genannten Nachteile vermieden werden können, und welches zu einer langen Lebensdauer des Niederspannungs-Schutzschaltgeräts führt.

Erfindungsgemäß wird dies durch die Merkmale des Patentanspruches 7 erreicht.

Dadurch können die vorstehend zum Niederspannungs-Schutzschaltgerät geltend gemachten Vorteile erzielt werden.

Ausdrücklich wird hiermit auf den Wortlaut der Patentansprüche Bezug genommen, wodurch die Ansprüche an dieser Stelle durch Bezugnahme in die Beschreibung eingefügt sind und als wörtlich wiedergegeben gelten.

Die Erfindung wird unter Bezugnahme auf die beigeschlossenen Zeichnungen, in welchen lediglich bevorzugte Ausführungsformen beispielhaft dargestellt sind, näher beschrieben. Dabei zeigt:
Fig. 1 eine schematische Darstellung eines gegenständlichen Niederspannungs-Schutzschaltgeräts; und
Fig. 2 Details eines Niederspannungs-Schutzschaltgeräts gemäß Fig. 1.

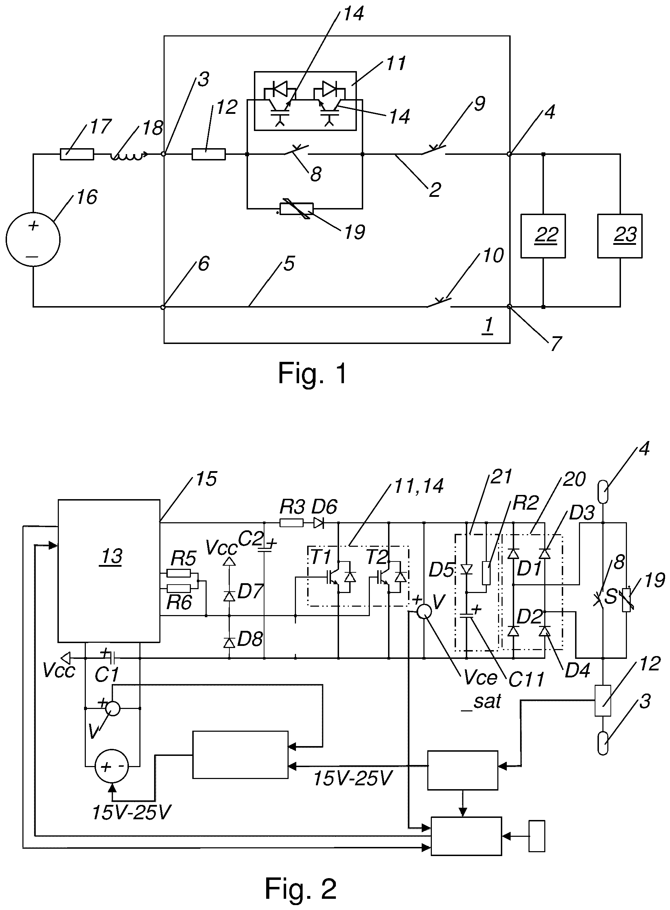

Die Fig. 1 zeigt ein Niederspannungs-Schutzschaltgerät 1 mit mindestens einer ersten Außenleiterstrecke 2 von einem Außenleiterversorgungsanschluss 3 des Niederspannungs-Schutzschaltgeräts 1 zu einem Außenleiterlastanschluss 4 des Niederspannungs-Schutzschaltgeräts 1, wobei in der Außenleiterstrecke 2 ein mechanischer Bypassschalter 8 angeordnet ist, wobei eine erste Halbleiterschaltungsanordnung 11 des Niederspannungs-Schutzschaltgeräts 1 parallel zum Bypassschalter 8 geschaltet ist, wobei die erste Halbleiterschaltungsanordnung 11 wenigstens Leistungshalbleiter aufweist, wobei das Niederspannungs-Schutzschaltgerät 1 eine Steuer- und Treibereinheit 13 zur Ansteuerung der ersten Halbleiterschaltungsanordnung 11 mit einer Steuerspannung aufweist, wobei die Steuer- und Treibereinheit 13 dazu ausgebildet ist, die erste Halbleiterschaltungsanordnung 11 in einem Normalbetrieb des Niederspannungs-Schutzschaltgeräts 1 mit einem ersten Spannungswert der Steuerspannung durchzuschalten, wobei der erste Spannungswert geringer ist als eine Spitzensteuerspannung des Leistungshalbleiters, wobei die Steuer- und Treibereinheit 13 dazu ausgebildet ist bei Detektion eines Kurzschlussstromes oder eines Überstromes in einem ersten Schritt die Steuerspannung vom ersten Spannungswert auf einen zweiten Spannungswert zu erhöhen, welcher zweite Spannungswert größer ist als die Spitzensteuerspannung des Leistungshalbleiters, und nachfolgend in einem zweiten Schritt die erste Halbleiterschaltungsanordnung 11 abzuschalten.

Besonders bevorzugt ist vorgesehen, dass der wenigstens eine Leistungshalbleiter wenigstens ein IGBT 14 oder MOSFET ist, dass die Steuerspannung eine Gate-Spannung des IGBT 14 oder MOSFET ist, und dass die Spitzensteuerspannung eine Gate-Spitzenspannung des IGBT 14 oder MOSFET ist. Nachfolgend wird die Erfindung anhand dieser bevorzugten Ausführungen beschrieben, wobei jedoch die Verwendung anderer Leistungshalbleiter weiterhin vorgesehen ist, insbesondere die Verwendung von bipolaren Transistoren.

Durch die gegenständliche Erfindung können auch hohe Kurzschlussströme mit nur einem einzigen Leistungshalbleiterbauteil, beispielsweise einem IGBT 14 oder MOSFET, sicher abgeschaltet werden, ohne dass es zu thermischen Problemen oder einer Beeinträchtigung der Lebensdauer des Niederspannungs-Schutzschaltgeräts 1 kommt. Natürlich können dadurch auch Überströme die geringer sind als ein Kurzschlussstrom sicher abgeschaltet werden.

Dadurch kann der Zustand der Entsättigung (desaturation) der Spannung beim Abschalten eines Überstromes oder Kurzschlussstromes sicher verhindert werden. Da keine Entsättigung (desaturation) an dem Leistungshalbleiter auftritt, kann dieser auch einen entsprechend hohen Strom bei geringer Verlustleistung übertragen. Dabei wird durch die Überhöhung der Gate-Spannung gegenüber der Gate-Spitzenspannung des IGBT 14 oder MOSFET keineswegs die Lebensdauer des Leistungshalbleiters verringert. Die entsprechenden Werte der Gate-Spitzenspannung sind in den Datenblättern jeweils für einen Dauerbetrieb des jeweiligen Bauteils definiert. Da die gegenständlich beschriebene Erhöhung der Gate-Spannung jedoch nur sehr kurzzeitig und auch nur beim Abschalten eines Überstromes oder Kurzschlusses, welche verhältnismäßig selten auftreten, erfolgt, wird der Leistungshalbleiter während einer typischen Lebensdauer des Niederspannungs-Schutzschaltgeräts von 20 bis 25 Jahren nur für wenige Millisekunden mit der deutlich überhöhten Gate-Spannung betrieben. Dies verringert die Lebensdauer des Leistungshalbleiters nicht. Dadurch kann die Lebensdauer eines Niederspannungs-Schutzschaltgeräts verlängert werden.

Durch die Verwendung nur eines einzigen Leistungshalbleiterbauteils können weiters die Leitungswege kurz und damit die Schleifeninduktivität gering gehalten werden, wodurch ein Kurzschlussstrom schneller auf den Leistungshalbleiter kommutiert. Dadurch kann die Zeitdauer, während derer der Leistungshalbleiter belastet wird weiters reduziert und die Lebensdauer weiter erhöht werden.

Das gegenständliche Schaltgerät ist ein Niederspannungs-Schutzschaltgerät 1. Als Niederspannung wird wie an sich üblich der Bereich bis 1000V Wechselspannung bzw. 1500V Gleichspannung bezeichnet.

Das Niederspannungs-Schutzschaltgerät 1 weist wenigstens eine Außenleiterstrecke 2 sowie eine Neutralleiterstrecke 5 auf. Bei Gleichstrom sind entsprechend zwei Leiterstrecken unterschiedlicher Polarität vorgesehen. Die Außenleiterstrecke 2 verläuft durch das Niederspannungs-Schutzschaltgerät 1 von einem Außenleiterversorgungsanschluss 3 zu einem Außenleiterlastanschluss 4. Die Neutralleiterstrecke 5 verläuft durch das Niederspannungs-Schutzschaltgerät 1 von einem Neutralleiteranschluss 6 zu einem Neutralleiterlastanschluss 7. Die betreffenden Anschlüsse 3, 4, 6, 7 sind jeweils bevorzugt als Schraubanschlussklemmen bzw. Steckanschlussklemmen ausgebildet, und in dem Niederspannungs-Schutzschaltgerät 1 von außen zugänglich angeordnet.

Das Niederspannungs-Schutzschaltgerät 1 weist bevorzugt wenigstens bereichsweise ein Isolierstoffgehäuse auf.

In der Außenleiterstrecke 2 ist ein mechanischer Bypassschalter 8 angeordnet.

Bevorzugt ist bei dem Niederspannungs-Schutzschaltgerät 1, wie dargestellt, in der Außenleiterstrecke 2 weiters ein erster mechanischer Trennschalter 9 seriell zum Bypassschalter 8 angeordnet. In der Neutralleiterstrecke 5 ist bevorzugt ein zweiter mechanischer Trennschalter 10 angeordnet. Die beiden Trennschalter dienen der Sicherstellung der galvanischen Trennung.

Parallel zum Bypassschalter 8 ist eine Halbleiterschaltungsanordnung 11 geschaltet.

Die Halbleiterschaltungsanordnung 11 ist als Vier-Quandranten-Schalter ausgelegt. Diese ist gegenständlich mit Back-to-Back-IGBT 14 dargestellt, wobei jedoch auch die Verwendung anderer IGBT 14 oder auch MOSFET vorgesehen sein kann. Je Halbwelle ist daher lediglich bzw. genau ein IGBT 14 vorgesehen.

Die IGBT 14 bzw. MOSFET werden von einer Steuer- und Treibereinheit 13 des Niederspannungs-Schutzschaltgeräts 1 angesteuert, welche bevorzugt umfassend einen Mikrocontroller bzw. Mikroprozessor ausgebildet ist.

Die Steuer- und Treibereinheit 13 ist dazu ausgebildet, den Bypassschalter 8 und die Halbleiterschaltungsanordnung 11, sowie den, bevorzugt vorgesehenen, ersten mechanischen Trennschalter 9 und den, bevorzugt vorgesehenen, zweiten mechanischen Trennschalter 10, anzusteuern, daher diese vorgebbar zu betätigen bzw. zu schalten. Hiezu ist die Steuer- und Treibereinheit 13 mit der Halbleiterschaltungsanordnung 11, sowie weiters mit, insbesondere elektromagnetischen, Betätigungselementen des ersten mechanischen Trennschalters 9 und des zweiten mechanischen Trennschalters 10 bevorzugt schaltungstechnisch verbunden. Die Steuer- und Treibereinheit 13 ist nicht in Fig. 1 dargestellt. In Fig. 2 ist ein erweitertes schaltungstechnisches Umfeld der Steuer- und Treibereinheit 13 dargestellt, wobei nicht sämtliche Baugruppen mit Bezugszeichen versehen sind.

Die Leistungshalbleiter, insbesondere die IGBT 14, sind in eine Diodengleichrichterschaltung eingebaut. In Fig.1 ist dies durch Back to Back IGBT gelöst. In Fig. 2 durch eine klassische Dioden-Brückenschaltung.

Weiters weist das Niederspannungs-Schutzschaltgerät 1 bevorzugt eine Gleichrichterschaltung 20 auf, welche ebenfalls parallel zum Bypassschalter 8 geschaltet ist. Dies ist lediglich in Fig. 2 dargestellt.

Ebenfalls lediglich in den Fig. 2 dargestellt ist ein Snubber-Schaltkreis 21.

Weiters ist parallel zum Bypassschalter 8 ein Überspannungsableiter bzw. Varistor 19 geschaltet.

Das Niederspannungs-Schutzschaltgerät 1 weist weiters eine Strommessanordnung 12 auf, welche in der Außenleiterstrecke 2 angeordnet ist, und welche bevorzugt umfassend einem Shunt-Widerstand ausgebildet ist.

Die Strommessanordnung 12 ist mit der Steuer- und Treibereinheit 13 des Niederspannungs-Schutzschaltgeräts 1 verbunden.

Neben der Strommessanordnung 12 ist die Steuer- und Treibereinheit 13 weiters dazu ausgebildet eine Entsättigung des IGBT 14 oder MOSFET zu detektieren. Dies ist an sich bereits in der WO 2015/028634 A1 der Anmelderin beschrieben. Hiezu weist die Steuer- und Treibereinheit 13 einen entsprechend beschalteten Eingang auf, welcher als Desaturation Detektion 15 bezeichnet wird. Dadurch kann ebenfalls das Auftreten eines Überlaststromes oder eines Kurzschlussstromes erkannt werden, und nachfolgend das Niederspannungs-Schutzschaltgerät 1 abgeschaltet werden. Dies ist insbesondere dann relevant, wenn des Niederspannungs-Schutzschaltgerät 1 bei bestehenden Überlast- bzw. Kurzschlussbedingungen in Betrieb genommen werden soll.

In Fig. 1 ist neben dem eigentlichen Niederspannungs-Schutzschaltgerät 1 weiters die elektrische Umgebung angedeutet. Dabei ist das Versorgungsnetz durch die AC/DC-Netzspannungsquelle 16, den Netzinnenwiderstand 17 und die Netzinduktivität 18 dargestellt. Weiters ist eine elektrische Last 23, sowie ein elektrischer Fehler 22 in Form eines Kurzschlusses dargestellt.

Das Einschalten des Niederspannungs-Schutzschaltgeräts 1 erfolgt wie in der WO 2015/028634 A1 der Anmelderin beschrieben. Dabei wird die Halbleiterschaltungsanordnung 11 eingeschaltet.

Es ist vorgesehen, dass der Leistungshalbleiter im Normalbetrieb mit einer Steuerspannung bzw. Gate-Spannung mit einem ersten Spannungswert betrieben, welcher erste Spannungswert geringer ist als eine Spitzensteuerspannung bzw. ein Gate-Spitzenspannung des Leistungshalbleiters bzw. des IGBT 14 oder MOSFET.

Insbesondere ist dabei vorgesehen, dass der erste Spannungswert so gering als möglich ist, und nur geringfügig über einer Gate-Schwellenspannung (Gate-Threshold Voaltage) des IGBT 14 oder MOSFET liegt. Vorzugsweise ist vorgesehen, dass der erste Spannungswert der Steuerspannung bzw. Gate-Spannung zwischen 100% und 150%, insbesondere zwischen 110% und 130%, einer Schwellensteuerspannung des Leistungshalbleiters bzw. einer Gate-Schwellenspannung des IGBT 14 oder MOSFET beträgt. Typischerweise beträgt die Gate-Schwellenspannung zwischen 5 V und 7 V bei einem IGBT und 3 V bis 4 V bei einem MOSFET. Durch diese geringen Spannungswerte wird die Lebensdauer des Leistungshalbleiters verlängert.

Sofern bereits beim Einschalten ein Kurzschluss vorliegen sollte, wird dies durch die Desaturation Detektion 15 erkannt. Da der Strom, an dem die Desaturation auftritt, mit sinkender Gate-Spannung ebenfalls sinkt, wird ein solcher Kurzschluss schneller erkannt, als beim Einschalten der Halbleiterschaltungsanordnung 11 mit einer hohen Gate-Spannung, sodass der Kurzschluss schneller erkannt und abgeschaltet werden kann. Es hat sich dabei gezeigt, dass in diesem Fall ein Kurzschluss schneller über die Desaturation Detektion 15 erkannt wird, als über die Strommessanordnung 12. Nach erfolgter Detektion einer Entsättigung wird die Halbleiterschaltungsanordnung 11 durch die Steuer- und Treibereinheit 13 direkt abgeschaltet, ohne vorherige Erhöhung der Steuerspannung.

Allerdings hat es sich in diesem Zusammenhang als besonders vorteilhaft erwiesen, wenn der Leistungshalbleiter lediglich während des Einschaltens für eine sog. Einschaltzeitspanne, welche bevorzugt zwischen 50 µs bis 500 µs, insbesondere im Wesentlichen 100 µs, beträgt, mit einer Steuerspannung mit einem dritten Spannungswert, welcher in einem Mittenbereich zwischen der Schwellensteuerspannung und der Spitzensteuerspannung liegt, eingeschaltet wird. Nachfolgend wird die Steuerspannung auf den ersten Spannungswerte abgesenkt. Insbesondere beträgt die dritte Steuerspannung zwischen 40% und 60% der Spitzensteuerspannung. Dadurch können Fehlauslösungen während des Einschaltens vermieden werden, welche aus sog. Spitzenströmen bzw. inrush currents resultieren können.

Sofern kein Fehler vorliegt, wird das Bypassrelais 8 geschlossen und die Halbleiterschaltungsanordnung 11 bleit mit der Gate-Spannung mit einem ersten Spannungswert eingeschaltet.

Zum Ausschalten des Niederspannungs-Schutzschaltgeräts 1 bei Vorliegen eines Stromes, welcher maximal dem vorgesehenen Betriebsstrom entspricht, steuert die Steuer- und Treibereinheit 13 das Bypassrelais 8 an die Kontakte zu öffnen, woraufhin der Laststrom vollständig auf die Halbleiterschaltungsanordnung 11 kommutiert.

Sobald die Kontakte des Bypassrelais 8 einen ausreichenden Abstand aufweisen, wird die Halbleiterschaltungsanordnung 11 abgeschaltet. Hiezu wird eine erste Zeitspanne abgewartet, wobei man davon ausgehen kann, dass nach dieser ersten Zeitspanne, welche einfach experimentell ermittelt werden kann, die Kontakte des Bypassrelais 8 den ausreichenden Abstand aufweisen. Die durch den Abschaltvorgang entstehenden Spannungsspitzen werden im Varistor 19 bzw. Snubber 21 abgebaut. Nachfolgend werden die Trennschalter 9, 10 geöffnet.

Sobald ein Kurzschluss oder Überstrom detektiert wurde, ist vorgesehen, dass die Steuer- und Treibereinheit 13 das Öffnen des Bypassrelais 8 veranlasst und dieses entsprechend ansteuert. Gleichzeitig erhöht die Steuer- und Treibereinheit 13 in einem ersten Schritt die Gate-Spannung der Halbleiterschaltungsanordnung 11 vom ersten Spannungswert auf einen zweiten Spannungswert, wobei der zweite Spannungswert größer ist als die Gate-Spitzenspannung des IGBT 14 oder MOSFET. Dabei reagiert der Leistungshalbleiter derart schnell, dass die höhere Steuerspannung bereits anliegt bevor der Strom auf diesen kommutiert.

Bevorzugt ist vorgesehen, dass der zweite Spannungswert zwischen 120% und 170%, insbesondere zwischen 130% und 160%, der Spitzensteuerspannung des Leistungshalbleiters beträgt. Insbesondere ist bei der bevorzugten Ausbildung des Leistungshalbleiters als IGBT 14 oder MOSFET vorgesehen, dass der zweite Spannungswert zwischen 120% und 170%, insbesondere zwischen 130% und 160%, der Gate-Spitzenspannung des IGBT 14 oder MOSFET beträgt. Bei einer verbreiteten Gate-Spitzenspannung von 20 V bei einem IGBT entspricht dies typischen Spannungen zwischen 24 V bis 34 V.

Leistungshalbleiter sind in der Lage derart hohe Gate-Spannungen bei seltenen Schaltvorgängen zu verkraften. Durch diese hohen Gate-Spannungen wird auch bei hohen Strömen über den IGBT 14 oder MOSFET keine Entsättigung verursacht und der IGBT 14 oder MOSFET in Sättigung betrieben.

Die Öffnung des Bypassrelais 8 und die Erhöhung der Gate-Spannung kann im Wesentlichen gleichzeitig erfolgen, da das Erhöhen der Gate-Spannung wesentlich schneller erfolgt, als das Öffnen des Bypassreals 8.

Nachdem die Kontakte des Bypassrelais 8 einen ausreichenden Abstand aufweisen, schaltet die Steuer- und Treibereinheit 13 in einem nachfolgenden zweiten Schritt die Halbleiterschaltungsanordnung 11 ab. Hiezu wartet die Steuer- und Treibereinheit 13 bevorzugt eine vorgebbare bzw. zuvor definierte erste Zeitspanne ab, bevor diese den zweiten Schritt ausführt. Dadurch kann sichergestellt werden, dass das Bypassrelais 8 geöffnet hat, und der Strom voll auf die Halbleiterschaltungsanordnung 11 kommutiert ist bevor diese abgeschaltet wird.

Die entstehenden Spannungsspitzen werden über den Varistor 19 bzw. Snubber 21 abgeführt.

Die Steuer- und Treibereinheit 13 ist dazu ausgebildet die beschriebenen Schritte in einem entsprechenden Verfahren auszuführen. Dabei wird durch die Steuer- und Treibereinheit 13 bei Detektion eines Kurzschlussstromes oder Überstromes in einem ersten Schritt die Gate-Spannung vom ersten Spannungswert auf einen zweiten Spannungswert erhöht, welcher zweite Spannungswert größer ist als die Gate-Spitzenspannung des IGBT 14 oder MOSFET, wobei die Steuer- und Treibereinheit 13 in einem nachfolgenden zweiten Schritt die Halbleiterschaltungsanordnung 11 abschaltet.

## Patentansprüche

1. Niederspannungs-Schutzschaltgerät (1) mit mindestens einer ersten Außenleiterstrecke (2) von einem Außenleiterversorgungsanschluss (3) des Niederspannungs-Schutzschaltgeräts (1) zu einem Außenleiterlastanschluss (4) des Niederspannungs-Schutzschaltgeräts (1), wobei in der Außenleiterstrecke (2) ein mechanischer Bypassschalter (8) angeordnet ist, wobei eine erste Halbleiterschaltungsanordnung (11) des Niederspannungs-Schutzschaltgeräts (1) parallel zum Bypassschalter (8) geschaltet ist, wobei die erste Halbleiterschaltungsanordnung (11) wenigstens Leistungshalbleiter aufweist, wobei das Niederspannungs-Schutzschaltgerät (1) eine Steuer- und Treibereinheit (13) zur Ansteuerung der ersten Halbleiterschaltungsanordnung (11) mit einer Steuerspannung aufweist, wobei die Steuer- und Treibereinheit (13) dazu ausgebildet ist, die erste Halbleiterschaltungsanordnung (11) in einem Normalbetrieb des Niederspannungs-Schutzschaltgeräts (1) mit einem ersten Spannungswert der Steuerspannung durchzuschalten, wobei der erste Spannungswert geringer ist als eine Spitzensteuerspannung des Leistungshalbleiters, **dadurch gekennzeichnet, dass** die Steuer- und Treibereinheit (13) dazu ausgebildet ist bei Detektion eines Kurzschlussstromes oder eines Überstromes in einem ersten Schritt die Steuerspannung vom ersten Spannungswert auf einen zweiten Spannungswert zu erhöhen, welcher zweite Spannungswert größer ist als die Spitzensteuerspannung des Leistungshalbleiters, und nachfolgend in einem zweiten Schritt die erste Halbleiterschaltungsanordnung (11) abzuschalten.

2. Niederspannungs-Schutzschaltgerät (1) nach Anspruch 1, **dadurch gekennzeichnet, dass** der wenigstens eine Leistungshalbleiter wenigstens ein IGBT (14) oder MOSFET ist, dass die Steuerspannung eine Gate-Spannung des IGBT (14) oder MOSFET ist, und dass die Spitzensteuerspannung eine Gate-Spitzenspannung des IGBT (14) oder MOSFET ist.

3. Niederspannungs-Schutzschaltgerät (1) nach Anspruch 1 oder 2, **dadurch gekennzeichnet, dass** der erste Spannungswert der Steuerspannung zwischen 100% und 150%, insbesondere zwischen 110% und 130%, einer Schwellensteuerspannung des Leistungshalbleiters beträgt.

4. Niederspannungs-Schutzschaltgerät (1) nach Anspruch 1, 2 oder 3, **dadurch gekennzeichnet, dass** der zweite Spannungswert zwischen 120% und 170%, insbesondere zwischen 130% und 160%, der Spitzensteuerspannung des Leistungshalbleiters beträgt.

5. Niederspannungs-Schutzschaltgerät (1) nach einem der Ansprüche 1 bis 4, **dadurch gekennzeichnet, dass** Steuer- und Treibereinheit (13) weiters dazu ausgebildet ist eine Entsättigung des Leistungshalbleiters zu detektieren, und nach erfolgter Detektion einer Entsättigung die Halbleiterschaltungsanordnung (11) abzuschalten.

6. Niederspannungs-Schutzschaltgerät (1) nach einem der Ansprüche 1 bis 5, **dadurch gekennzeichnet, dass** Steuer- und Treibereinheit (13) weiters dazu ausgebildet ist zwischen dem ersten Schritt und dem zweiten Schritt eine vorgebbare erste Zeitspanne abzuwarten.

7. Verfahren zum Betrieb eines Niederspannungs-Schutzschaltgerät (1) mit mindestens einer ersten Außenleiterstrecke (2) wobei in der Außenleiterstrecke (2) ein mechanischer Bypassschalter (8) angeordnet ist, wobei eine Halbleiterschaltungsanordnung (11) des Niederspannungs-Schutzschaltgeräts (1) parallel zum Bypassschalter (8) geschaltet ist, wobei die Halbleiterschaltungsanordnung (11) wenigstens einen Leistungshalbleiter aufweist, wobei das Niederspannungs-Schutzschaltgerät (1) eine Steuer- und Treibereinheit (13) zur Ansteuerung der Halbleiterschaltungsanordnung (11) mit einer Steuerspannung aufweist, wobei die Steuer- und Treibereinheit (13) die Halbleiterschaltungsanordnung (11) in einem Normalbetrieb des Niederspannungs-Schutzschaltgeräts (1) mit einem ersten Spannungswert der Steuerspannung durchschaltet, wobei der erste Spannungswert geringer ist als eine Spitzensteuerspannung des Leistungshalbleiters, **dadurch gekennzeichnet, dass** die Steuer- und Treibereinheit (13) bei Detektion eines Kurzschlussstromes oder Überstromes in einem ersten Schritt die Steuerspannung vom ersten Spannungswert auf einen zweiten Spannungswert erhöht, welcher zweite Spannungswert größer ist als die Spitzensteuerspannung des Leistungshalbleiters, und dass die Steuer- und Treibereinheit (13) in einem nachfolgenden zweiten Schritt die Halbleiterschaltungsanordnung (11) abschaltet.

## Claims

1. Low-voltage protective device (1), having at least one first outer conductor path (2) from an outer conductor power supply connection (3) of the low-voltage protective device (1) to an outer conductor load connection (4) of the low-voltage protective device (1), wherein a mechanical bypass switch (8) is arranged in the outer conductor path (2), wherein a first semiconductor circuit arrangement (11) of the low-voltage protective device (1) is connected in parallel to the bypass switch (8), wherein the first semiconductor circuit arrangement (11) has at least one power semiconductor, wherein the low-voltage protective device (1) has a control and driver unit (13) for driving the first semiconductor circuit arrangement (11) with a control voltage, wherein the control and driver unit (13) is configured to connect the first semiconductor circuit arrangement (11) in a normal operation of the low-voltage protective device (1) to a first voltage value of the control voltage, wherein the first voltage value is less than a peak control voltage of the power semiconductor, **characterised in that** the control and driver unit (13) is configured in a first step to increase the control voltage from the first voltage value to a second voltage value upon detection of a short-circuit current or an overcurrent, which second voltage value is greater than the peak control voltage of the power semiconductor, and subsequently in a second step to switch off the first semiconductor circuit arrangement (11).

2. Low-voltage protective device (1) according to claim 1, **characterised in that** the at least one power semiconductor is at least one IGBT (14) or MOSFET, **in that** the control voltage is a gate voltage of the IGBT (14) or MOSFET, and **in that** the peak control voltage is a peak gate voltage of the IGBT (14) or MOSFET.

3. Low-voltage protective device (1) according to claim 1 or 2, **characterised in that** the first voltage value of the control voltage is between 100% and 150%, in particular between 110% and 130%, of a threshold control voltage of the power semiconductor.

4. Low-voltage protective device (1) according to claim 1, 2 or 3, **characterised in that** the second voltage value is between 120% and 170%, in particular between 130% and 160%, of the peak control voltage of the power semiconductor.

5. Low-voltage protective device (1) according to any of claims 1 to 4, **characterised in that** the control and driver unit (13) is also configured to detect a desaturation of the power semiconductor, and to switch off the semiconductor circuit arrangement (11) after the detection of desaturation.

6. Low-voltage protective device (1) according to any of claims 1 to 5, **characterised in that** the control and driver unit (13) is also configured to wait for a definable first period of time between the first step and the second step.

7. Method for operating a low-voltage protective device (1), comprising at least one first outer conductor path (2), wherein a mechanical bypass switch (8) is arranged in the outer conductor path (2), wherein a semiconductor circuit arrangement (11) of the low-voltage protective device (1) is connected in parallel with the bypass switch (8), wherein the semiconductor circuit arrangement (11) has at least one power semiconductor, wherein the low-voltage protective device (1) has a control and driver unit (13) for controlling the semiconductor circuit arrangement (11) with a control voltage, wherein the control and driver unit (13) connects the semiconductor circuit arrangement (11) in a normal operation of the low-voltage protective device (1) with a first voltage value of the control voltage, wherein the first voltage value is lower than a peak control voltage of the power semiconductor, **characterised in that** the control and driver unit (13) upon detection of a short-circuit current or an overcurrent in a first step increases the control voltage from the first voltage value to a second voltage value, the second voltage value being greater than the peak control voltage of the power semiconductor, and **in that** the control and driver unit (13) in a subsequent, second step switches off the semiconductor circuit arrangement (11).

## Revendications

1. Disjoncteur basse tension (1) avec au moins un premier trajet de conducteur extérieur (2) d'un raccordement d'alimentation de conducteur extérieur (3) du disjoncteur basse tension (1) à un raccordement de charge de conducteur extérieur (4) du disjoncteur basse tension (1), dans lequel un commutateur de dérivation (8) mécanique est disposé dans le trajet de conducteur extérieur (2), dans lequel un premier ensemble circuit à semi-conducteurs (11) du disjoncteur basse tension (1) est monté parallèlement au commutateur de dérivation (8), dans lequel le premier ensemble circuit à semi-conducteurs (11) présente au moins des semi-conducteurs de puissance, dans lequel le disjoncteur basse tension (1) présente une unité de commande et d'attaque (13) permettant de commander le premier ensemble circuit à semi-conducteurs (11) avec une tension de commande, dans lequel l'unité de commande et d'attaque (13) est réalisée pour commuter le premier ensemble circuit à semi-conducteurs (11) dans un fonctionnement normal du disjoncteur basse tension (1) avec une première valeur de tension de la tension de commande, dans lequel la première valeur de tension est inférieure à une tension de commande de crête du semi-conducteur de puissance, **caractérisé en ce que** l'unité de commande et d'attaque (13) est réalisée, lors de la détection d'un courant de court-circuit ou d'une surintensité, au cours d'une première étape, pour augmenter la tension de commande de la première valeur de tension à une seconde valeur de tension, laquelle seconde valeur de tension est supérieure à la tension de commande de crête du semi-conducteur de puissance, et ensuite, au cours d'une seconde étape, pour mettre le premier ensemble circuit à semi-conducteurs (11) hors circuit.

2. Disjoncteur basse tension (1) selon la revendication 1, **caractérisé en ce que** le au moins un semi-conducteur de puissance est au moins un transistor bipolaire à grille isolée (14) ou MOSFET, que la tension de commande est une tension de grille du transistor bipolaire à grille isolée (14) ou MOSFET, et que la tension de commande de crête est une tension de crête de grille du transistor bipolaire à grille isolée (14) ou MOSFET.

3. Disjoncteur basse tension (1) selon la revendication 1 ou 2, **caractérisé en ce que** la première valeur de tension de la tension de commande est comprise entre 100 % et 150 %, en particulier entre 110 % et 130 %, d'une tension de commande seuil du semi-conducteur de puissance.

4. Disjoncteur basse tension (1) selon la revendication 1, 2 ou 3, **caractérisé en ce que** la seconde valeur de tension est comprise entre 120 % et 170 %, en particulier entre 130 % et 160 % de la tension de commande de crête du semi-conducteur de puissance.

5. Disjoncteur basse tension (1) selon l'une quelconque des revendications 1 à 4, **caractérisé en ce que** l'unité de commande et d'attaque (13) est réalisée en outre pour détecter une désaturation du semi-conducteur de puissance, et, une fois la détection d'une désaturation effectuée, pour mettre l'ensemble circuit à semi-conducteurs (11) hors circuit.

6. Disjoncteur basse tension (1) selon l'une quelconque des revendications 1 à 5, **caractérisé en ce que** l'unité de commande et d'attaque (13) est réalisée en outre pour attendre un premier laps de temps pouvant être prédéfini entre la première étape et la seconde étape.

7. Procédé pour faire fonctionner un disjoncteur basse tension (1) avec au moins un premier trajet de conducteur extérieur (2), dans lequel un commutateur de dérivation (8) mécanique est disposé dans le trajet de conducteur extérieur (2), dans lequel un ensemble circuit à semi-conducteurs (11) du disjoncteur basse tension (1) est monté parallèlement au commutateur de dérivation (8), dans lequel l'ensemble circuit à semi-conducteurs (11) présente au moins un semi-conducteur de puissance, dans lequel le disjoncteur basse tension (1) présente une unité de commande et d'attaque (13) permettant de commander l'ensemble circuit à semi-conducteurs (11) avec une tension de commande, dans lequel l'unité de commande et d'attaque (13) est réalisée pour commuter l'ensemble circuit à semi-conducteurs (11) dans un fonctionnement normal du disjoncteur basse tension (1) avec une première valeur de tension de la tension de commande, dans lequel la première valeur de tension est inférieure à une tension de commande de crête du semi-conducteur de puissance, **caractérisé en ce que** l'unité de commande et d'attaque (13) est réalisée, lors de la détection d'un courant de court-circuit ou d'une surintensité, au cours d'une première étape, pour augmenter la tension de commande de la première valeur de tension à une seconde valeur de tension, laquelle seconde valeur de tension est supérieure à la tension de commande de crête du semi-conducteur de puissance, et que l'unité de commande et d'attaque (13), au cours d'une seconde étape subséquente, met l'ensemble circuit à semi-conducteurs (11) hors circuit.
